# EUROPEAN PATENT SPECIFICATION

(11) **EP 2 557 633 B1**
(45) Date of publication and mention of the grant of the patent: **30.05.2018**
(21) Application number: 11765647.0
(22) Date of filing: 30.03.2011
(51) Int. Cl.: H01R 13/03, H01R 12/58, H05K 3/30

(54) **PRESS FIT TERMINAL AND SEMICONDUCTOR MODULE**
PRESSPASSUNGS-ANSCHLUSS UND HALBLEITERMODUL
BORNE ENGAGEE A LA PRESSE ET MODULE SEMI-CONDUCTEUR

(30) Priority: 07.04.2010 JP 2010088597
(43) Date of publication of application: 13.02.2013
(73) Proprietor: Mitsubishi Electric Corporation, Tokyo 100-8310 (JP)
(72) Inventor: EGUSA Minoru, Tokyo 100-8310 (JP); SUDO Shingo, Tokyo 100-8310 (JP); HAYASHI Kenichi, Tokyo 100-8310 (JP)
(74) Representative: Sajda, Wolf E.
(86) International application number: PCT/JP2011/058025
(87) International publication number: WO 2011/125747

(56) References cited:
- JP-A- 2007 265 641
- JP-A- 2008 059 812
- US-A- 5 004 426
- US-A- 5 374 204
- US-A1- 2006 040 545
- US-B1- 6 997 727

## Description

### Technical Field

The present invention relates to a press-fit terminal and a semiconductor module provided with a press-fit terminal and particularly to a structure of a press-fit terminal that can reduce a contact resistance between the press-fit terminal and a through-hole, without increasing press-fitting force when the press-fit terminal is pressed into the through-hole, which is a female electrode.

### Background Art

Among semiconductor modules, a power semiconductor module is utilized in a vehicle such as a railway vehicle, a hybrid car, or an electric vehicle, an electric household appliance, or an industrial machine, for the purpose of controlling and rectifying relatively large electric power. Accordingly, a semiconductor device utilized in a power semiconductor module needs to operate with a high current density of more than 100 A/cm².

Therefore, in recent years, as a semiconductor material that replaces silicon (Si), silicon carbide (SiC), which is a material of a wide bandgap semiconductor, has been drawing attention; a semiconductor device made of SiC can operate with a higher current density than a semiconductor device made of Si.

However, with regard to a power semiconductor module that is operated with a high current density, the cross-sectional area of the terminal through which a current flows into the power semiconductor module needs to be enlarged so as to deal with a large current. Thus, the heat capacity of the terminal has become large and hence soldering has become difficult; therefore, a terminal that does not require soldering has been being required.

As a terminal connecting method in which no soldering is implemented, press-fit connecting has been known to date in which a terminal is press-fit into and is made to contact with a through-hole, which is a female electrode on a wiring board. In the press-fit connecting, through repulsive force, of a press-fit terminal, that is generated after the press-fit terminal is press-fit, electric connection is established by the mechanical contact with the inner wall of a through-hole; thus, it is an important technical issue to maintain the contact force.

Thus, there has been proposed a press-fit terminal (for example, refer to Patent Document 1) in which its press-contact portions that are integrated with each other at both ends in the press-in direction and that separate from each other in a direction perpendicular to the press-in direction are formed in such a way as to have L-shaped portions that are oriented to the opposite directions on a cross section perpendicular to the press-in direction so that through repulsive force against the deformation at the L-shaped portions in addition to the deformation at both ends, the contact force is enhanced.

### Prior Art References

### Patent Documents

Patent Document 1 Japanese Patent Application Laid-Open JP-A-2007-265 641 (paragraphs [0024] and [0030], FIGS. 3, 4, and 5)

US 5 374 204 A is further prior art according to the preamble of claim 1.

### Disclosure of the Invention

### Problem(s) to be Solved by the Invention

However, in the case where such a press-fit terminal as described above is applied to a power semiconductor module in which a large current flows, it is required to reduce the resistance of the terminal; therefore, the board thickness of the terminal needs to be kept at a constant value or larger. However, for the purpose of forming an L-shaped portion on a cross section perpendicular to the press-in direction, extra processing such as spinning processing is required; thus, it is difficult to perform accurate processing by use of a thick board.

The present invention has been implemented in order to solve the foregoing problems; the objective thereof is to obtain a press-fit terminal that can be worked readily and accurately and can reduce the contact resistance between the press-fit terminal and a through-hole, which is a female electrode, without increasing the press-fitting force when it is pressed into the through-hole and to obtain a semiconductor module provided with the press-fit terminal.

### Means for Solving the Problem

A press-fit terminal according to the present invention is given in claim 1 and is adapted to be, amongst others, pressed into a through-hole for electrical contact so as to perform electrical connection; the press-fit terminal is configured in such a way that there are laminated in a thickness direction a plurality of press-fit terminal units, each of which is made of a plate material and includes a front end portion formed in the shape of a taper and press-contact portion that is formed in such a way to have a pair of portions branched from the front end portion, and respective side faces of the pair of portions face each other through a predetermined spacing, and that are adapted to be inserted and pressed into the through-hole; the press-fit terminal is characterized in that respective board thicknesses of the plurality of press-fit terminal units are smaller than width of the predetermined spacing or respective widths of the pair of portions that is branched from the front end portion.

### Advantage of the Invention

A press-fit terminal according to the present invention is configured by laminating thin press-fit terminal units in the thickness direction; therefore, there can be obtained a press-fit terminal that can be worked readily and accurately and can reduce the contact resistance between the press-fit terminal and a through-hole, without increasing the press-fitting force when being
pressed into a through-hole and to obtain a power semiconductor module provided with the press-fit terminal.

### Brief Description of the Drawings

- FIG. 1: is a set of views for explaining the configuration of a press-fit terminal according to Embodiment 1 of the present invention;
- FIG. 2: is a set of views for explaining the configuration of a wiring board through-hole, which is a female electrode, for explaining the configuration of a press-fit terminal according to Embodiment 1 of the present invention;
- FIG. 3: is a set of views for explaining the status at a time when a press-fit terminal according to Embodiment 1 of the present invention is pressed into a wiring board through-hole;
- FIG. 4: is a view for explaining the status at a time when a press-fit terminal, according to Embodiment 1 of the present invention, whose press-contact portions are not integrated with each other, is pressed into a wiring board through-hole;
- FIG. 5: is a view for explaining the configuration of a press-fit terminal according to a variant example of Embodiment 1 of the present invention;
- FIG. 6: is a view for explaining the configuration of a press-fit terminal according to a variant example of Embodiment 1 of the present invention;
- FIG. 7: is a view for explaining the configuration of a press-fit terminal according to a variant example of Embodiment 1 of the present invention;
- FIG. 8: is a view for explaining the configuration of a press-fit terminal according to a variant example of Embodiment 1 of the present invention;
- FIG. 9: is a view for explaining the configuration of a press-fit terminal according to Embodiment 2 of the present invention;
- FIG. 10: is a view for explaining the configuration of a press-fit terminal according to Embodiment 3 of the present invention;
- FIG. 11: is a view for explaining the configuration of a press-fit terminal according to Embodiment 4 of the present invention;
- FIG. 12: is a set of views for explaining the status and the dimensional relationship at a time when a press-fit terminal according to Embodiment 5 of the present invention is pressed into a wiring board through-hole;
- FIG. 13: is a set of views for explaining the status and the dimensional relationship at a time when a press-fit terminal according to Embodiment 6 of the present invention is pressed into a wiring board through-hole;
- FIG. 14: is a set of views for explaining the inner configuration of a power semiconductor module according to Embodiment 7 of the present invention;
- FIG. 15: is a set of views for explaining the appearance of a power semiconductor module according to Embodiment 7 of the present invention; and
- FIG. 16: is a set of views for explaining the appearance of a power semiconductor module according to a variant example of Embodiment 7 of the present invention.

### Best Mode for Carrying Out the Invention

### Embodiment 1

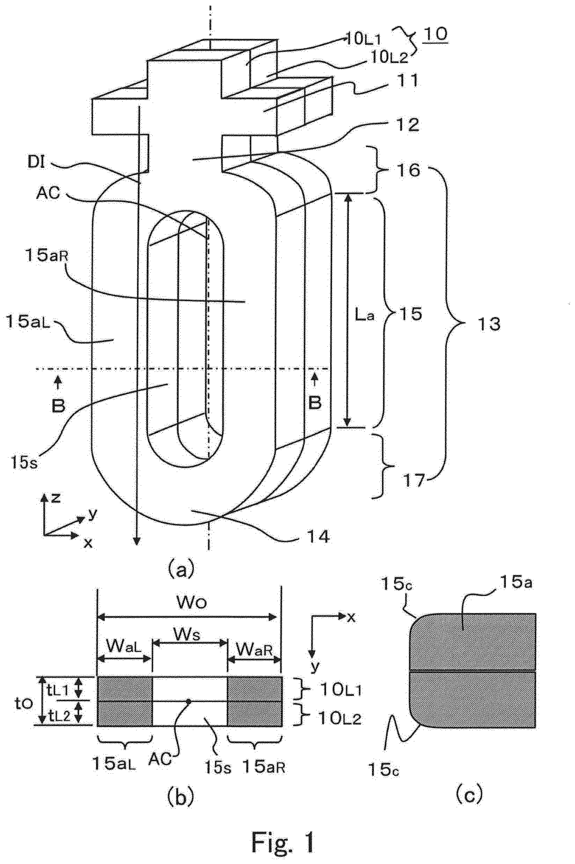

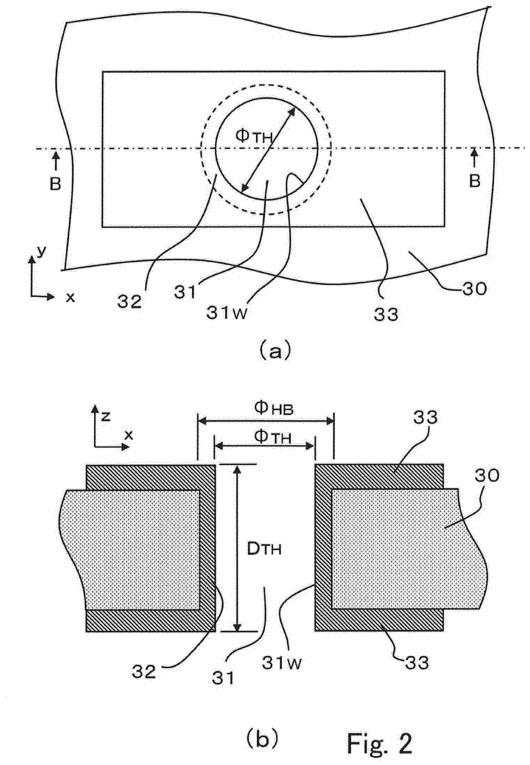

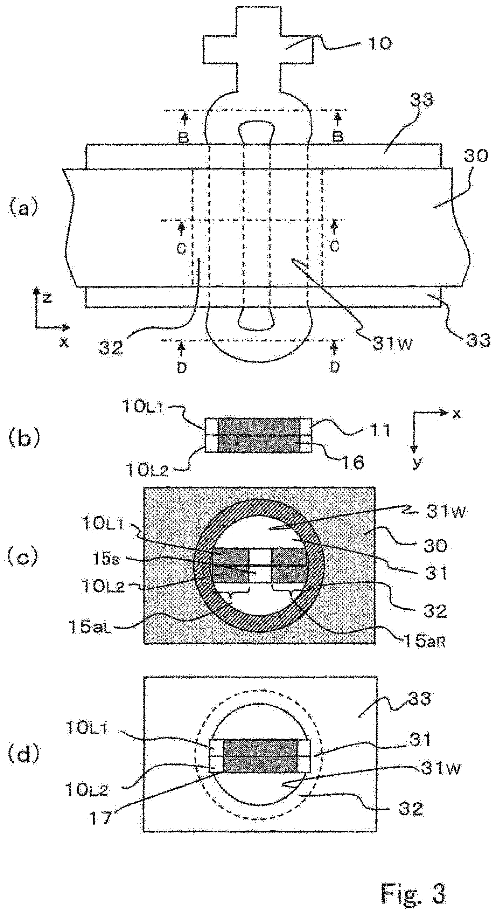

FIGS. 1 through 3 are diagrams for explaining the configuration of a press-fit terminal according to Embodiment 1 of the present invention; FIG. 1 is a set of external and cross-sectional views for explaining the configuration of a press-fit terminal; FIG. 2 is a set of plan and cross-sectional views of a wiring board through-hole that is a female electrode and into (with) which a press-fit terminal is pressed (connected); FIG. 3 is a set of side and cross-sectional plan views for explaining the status at a time when a press-fit terminal is pressed into a through-hole. The details will be explained below.

In FIG. 1, a press-fit terminal 10 includes a press-fit portion 13 that is pressed into a through-hole 31 (FIG. 2), which is a hollow and cylindrical penetrated hole provided in a wiring board (FIG. 2), and other portions. The press-fit portion 13 includes: a front end portion 14 that is the front end in the press-in direction of the terminal and is tapered due to tapered portion 17, a tapered portion 16 in the vicinity of a base portion 12, and a press-contact portion 15 that is situated between the tapered portions 17 and 16 and in which in the xz plane including the press-in direction (z direction) DI, an opening portion 15s is formed between a pair of branch portions 15aL and 15aR (collectively referred to as 15a) that are separated from each other and extend in the direction (x direction) perpendicular to the press-in direction DI.

As far as the dimensions of the press-fit portion 13 are concerned, as illustrated in FIG. 1(b), the thickness tₒ is 1.0 mm and the width Wo is 2.2 mm; the press-fit portion 13 is configured by laminating press-fit terminal units 10_{L1} and 10_{L2} (collectively, referred to as 10_{L}) in each of which the front end portion 14 and the press-contact portion 15 are formed in a copper or copper-alloy strip-shaped plain plate.

The press-contact portion 15 is in an axisymmetry with respect to the center axis AC that is parallel to the press-in direction DI of the press-fit terminal 10; furthermore, it is desirable that the right branch portion 15a and the left branch portion 15a are in a plane symmetry with respect to the plane (zy plane) including the center axis AC (z direction) and the laminating direction (y direction) of the thin plate 10L.

It is desirable that the tapered portion 17 of the front end portion 14 is approximately parallel to the press-in direction DI of the terminal 10, i.e., the tapered portion 17 has a gentle angle, for the purpose of reducing a load on an inner wall 31w of the through-hole 31.

It is also desirable that because the contact area between the press-contact portion 15 and the inner wall 31w of the through-hole 31 needs to be large when a large current flows, the length La of the press-contact portion 15 in the press-in direction DI, which coincides with the thickness direction of the through-hole 31 when the terminal is inserted, is larger than a thickness D_{TH} (in FIG. 2(b)) of the through-hole 31 (wiring board).

It is also desirable that for the purpose of increasing the contact area between the inner wall 31w of the through-hole 31 and the press-contact portion 15 when the terminal is pressed into the through-hole 31, chamfering is applied, as illustrated in FIG. 1(c), to a portion 15c, in the press-contact portion 15, that corresponds to one of four corners of a cross section, of the press-contact portion 15, that is perpendicular to the press-in direction DI.

The chamfering increases the contact area between the inner wall 31w of the through-hole 31 and the press-contact portion 15 of the press-fit terminal 10, whereby the electric resistance is reduced.

A bearing portion 11 is provided in the horizontal direction on both sides of the base portion 12 of the press-fit terminal, for the purpose of performing fixing or pressing-in with a jig when the terminal is pressed into the through-hole 31.

The bearing portion 11 is required when the press-fit terminal unit by itself is pressed into the through-hole 31; however, for example, because when the press-fit terminal is utilized as an electrode terminal of a power module, the terminal is integrated with the module, the bearing portion 11 is not necessarily required.

As illustrated in FIG. 1(b), the press-fit terminal 10 according to the present invention is characterized in that the board thickness tₒ of the press-fit terminal 10, as a terminal, is 1.0 mm but the press-fit terminal 10 is divided into two pieces in the board-thickness direction. In other words, the press-fit terminal 10 is formed by laminating and integrating (adhering) the press-fit terminal units 10_{L1} and 10_{L2}, each of which is a press-fit-shaped plain plate having a board thickness t_{L1} (t_{L2}) of 0.5 mm.

It is desirable that plating with tin or the like is applied to the surface of the press-fit terminal 10 for the purpose of preventing the terminal base material from being oxidized and reducing the contact resistance at a portion thereof that makes contact with the inner wall 31 of the through-hole.

In addition, it is preferable that as the base material, a copper or copper-alloy thin plate having a high conductivity is utilized; however, a conductive material other than copper, such as aluminum, may be utilized.

Here, the through-hole 31, of the wiring board 30, that is a female electrode and into which the press-fit terminal 10 is pressed will be explained with reference to FIG. 2. FIG. 2(a) is a plan view illustrating the vicinity of the through-hole 31 provided in the wiring board 30; FIG. 2(b) is a cross-sectional view taken along the line B-B in FIG. 2(a).

In FIG. 2, a copper wiring conductor 33 having a thickness of 35 µmis formed on each of both sides of the wiring board 30 having a thickness of 1.6 mm. In the through-hole 31, after a penetrated hollow having a diameter φ_{HB} of 2.05 mm has been created along with the copper wiring conductor 33 in the wiring board 30, a copper-made electric contact 32 having a thickness of 25 mm is formed through plating processing on the inner circumferential surface of the penetrated hollow.

As far as the finished dimensions of the through-hole 31 obtained after the plating processing are concerned, the diameter φ_{TH} is 2.00 mm and the depth D_{TH} is 1.67 mm. In addition, the surface of the copper wiring conductor 33 on both sides of the wiring board 30 and the surface of the inner wall 31w of the through-hole, i.e., the contact 32 on the inner circumferential surface of the through-hole 31 are coated with a water-soluble preflux, which is commonly utilized for the purpose of preventing copper from being oxidized.

Instead of coating with a water-soluble preflux, plating processing with tin or the like or solder leveler processing may be utilized. The thickness of the board, the diameter of the through-hole, the thickness of the wiring conductor, and the thickness of the plating may appropriately be adjusted.

Next, the state where the press-fit terminal 10 is pressed into the through-hole 31 (connected with the female electrode) will be explained.

FIG. 3 is a set of views illustrating the deformation (shape) of the press-fit terminal at a time when the press-fit terminal 10 is pressed into the through-hole 31, of the wiring board 30, that is a female electrode; FIG. 3(a) is a side view of the press-fit terminal 10 at a time when the press-fit terminal 10 has been pressed into the through-hole 31; FIG. 3(b) is a cross-sectional view taken along the line B-B in FIG. 3(a); FIG. 3(c) is a cross-sectional view taken along the line C-C in FIG. 3(a); FIG. 3(d) is a cross-sectional view taken along the line D-D in FIG. 3(a).

When the press-fit terminal 10 is pressed into the through-hole 31, the right and left branch portions 15a_{L} and 15a_{R}, of the press-contact portion 15, expanded to the outside of the inner wall 31w of the through-hole 31 are contracted inward, whereby the opening portion 15s is contracted and hence the gap size is reduced.

In that situation, because being deformed with respect to the base portion 12 and the front end portion 14, the branch portions 15a_{L} and 15a_{R} exert repulsive force against the inner wall 31w of the through-hole; thus, the contact force thereof are enhanced.

The reason why the foregoing configuration has been adopted will be described below.

In general, a press-fit terminal is produced through press working. The reason why a press-fit terminal is produced through press working is that the cost of the press working is low and products of a same specification can accurately be mass-produced.

However, in press working, it is extremely difficult in terms of the working accuracy to work a workpiece in such a way that there is obtained the diameter of a circle or the dimension of the minor axis of an ellipse, which is smaller than the board thickness, i.e., there is obtained a shape in which the ratio of the board thickness to the opening portion (board thickness/the diameter of the opening portion = tₒ/Wₛ) is larger than "1".

In addition, work of punching a workpiece leaving a portion that is narrower than the board thickness, i.e., work of forming a press-contact portion narrower than the board thickness (work satisfying the equation "board thickness/width of the press-contact portion = tₒ/W_{aL} > 1") is difficult.

Therefore, there has been a problem that the yield rate is deteriorated and hence the production cost of the terminal increases. However, as described in Embodiment 1, a plurality of press-fit terminal units 10_{L1} and 10_{L2} obtained by simply punching the plane shape of a press-fit terminal in a thin board material are laminated so as to produce the press-fit terminal 10, so that the press-fit terminal 10 can readily and accurately be produced through press working.

The reason why the foregoing method works well is that because in the case where the press-fit terminal units 10_{L1} and 10_{L2}, described in Embodiment 1, are produced and laminated, the width Ws of the opening portion 15s and the width W_{aL} (W_{aR}) of the branch portion 15a becomes larger with respect to the board thickness because the respective board thicknesses t_{L1} and t_{L2} are small, and hence the working is readily carried out.

In the case where a hole having a same width is punched through a common working method in materials of different board thicknesses, the larger the board thickness is, the more difficult the working becomes, and the smaller the board thickness is, the easier the working becomes.

For example, in the case where the board thickness and the width of the opening portion 15s are 1 mm and 0.5 mm, respectively, the ratio of the board thickness to the width of the opening portion 15s is "2" when no division is made in the board-thickness direction; however, because the ratio of the thickness of the terminal unit to the width of the opening portion 15s is "1" when the board is divided into two pieces in the board-thickness direction, the working is readily carried out.

Moreover, by making the board thickness of the terminal unit thinner (the number of divisions is increased), the dimensional accuracy at a time when the working is carried out can be raised; as a result, the cost of the terminal is lowered.

Furthermore, because the working of the opening portion 15s becomes easy, the opening portion 15s and the contour portion of the terminal can concurrently be worked with a single punching press die. By implementing the working in such a manner, the number of dies can be reduced, whereby the cost for making the die can be curtailed.

In other words, by making each of the board thicknesses t_{L} of a plurality of the press-fit terminal units 10_{L} thinner than at least one of the width Ws of the opening portion 15s and each of the widths Wa of the branch portions 15a, the working can readily and accurately be carried out.

In the case of such a configuration as the press-fit terminal 10 according to Embodiment 1 in which shape-working can be applied to each of the terminal units obtained through thickness-direction division, the press-fit terminal can be produced even by etching working with which it is difficult to make an opening smaller than the board thickness of a working piece.

Etching working is a working method that does not require any die or the like and lowers the cost even in the case of a small-lot production. This method demonstrates an advantage that even in the case of a small lot of and a wide variety of terminals such as module electrode terminals, the press-fit terminal can be produced at a low cost.

As far as the press-fit terminal according to Embodiment 1 is concerned, there has been explained an example in which after working for each of the press-fit terminal units 10_{L} of the respective layers is carried out, the all press-fit terminal units 10_{L} are integrated with one another in the press-in direction DI. However, in the case where the press-contact portions 15 are also integrated with one another, the respective terminal units are collectively deformed when the press-fit terminal is being press-fitted or after the press-fit terminal has been press-fitted; therefore, because local contact-pressure force is exerted on the through-hole 31, the effect of reducing the press-fitting force is diminished, whereby a damage to the through-hole 31 may be caused.

Accordingly, in the case where only the base portions 12 and the front end portions 14 are integrated with one another and, in the press-contact portions 15, the terminal units are not fixed to one another, the respective press-fit terminal units separately conform to the shape of the inner wall 31w of the through-hole; thus, the substantial contact area between the press-fit terminal 10 and the inner wall 31w of the through-hole increases, whereby the resistance is further reduced.

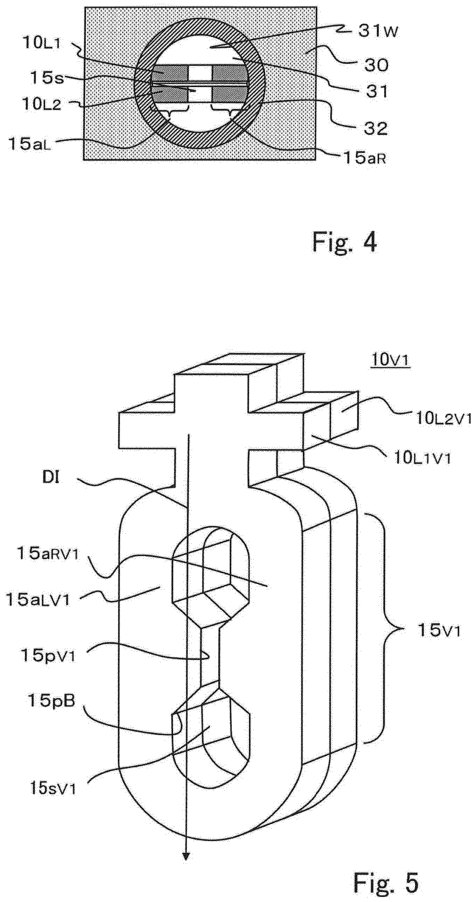

For example, FIG. 4 illustrates the state of the press-contact portion 15 corresponding to the state illustrated in FIG. 3(c), in the case where a press-fit terminal 10 in which in the press-contact portion 15, the terminal units are not fixed to each other is pressed into the through-hole 31. As illustrated in FIG. 4, each of the branch portions 15a of the terminal unit is deformed along the inner wall 31w.

Accordingly, because each of the branch portions 15a of the press-fit terminal units 10_{L1} and 10_{L2} separately exerts contact-pressure force on the inner wall 31w of the through-hole, press-fitting can be implemented with smaller press-fitting force and, after the press-fitting, no large contact-pressure force is exerted locally. Therefore, damage to the through-hole 31 can be suppressed.

Meanwhile, there may be caused a phenomenon that when the press-fit terminal is pressed into the through-hole 31, part of the press-fit terminal units among the laminated press-fit terminal units, especially, only the outmost-layer press-fit terminal units come out of the through-hole 31 and cannot be press-fitted in the case where, as described later, three or more layers of terminal units are laminated.

In order to prevent the foregoing phenomenon, the front end portions 14 that function as front end guides are integrated with each other. As a result, all the laminated press-fit terminal units, i.e., the press-fit terminal units of all the layers configuring the press-fit terminal can readily be guided into the through-hole 31.

Therefore, there can be prevented the possibility that during press-fitting, part of the press-fit terminal units come out of the through-hole 31 and make contact with the neighboring terminal, thereby causing a shortcircuit, and there can be prevented the situation that the conductive area of the terminal becomes insufficient and hence heat generation in the terminal is increased.

In the case where the base portions 12 of the terminal are adhered to and integrated with each other, the following effect is also demonstrated. In the case where the base portions 12 of the terminal are integrated with each other, the anti-buckling strength of the base portion 12 is raised, then during the press-fit terminal 10 is press-fitted, the press-fit portion 13 can normally be inserted into the through-hole 31, without causing a problem that due to buckling of the base portion 12, the press-fit terminal cannot be press-fitted into the through-hole 31.

Even in the case where the contact resistance between the laminated press-fit terminal unit 10_{L1} and the inner wall 31w and the contact resistance between the laminated press-fit terminal unit 10_{L2} and the inner wall 31w vary, the fact that at least the base portions 12 are integrated with each other makes the respective layers of the press-fit terminal to be thermally and electrically connected with each other; thus, when a large current flows, local heating can be suppressed. Therefore, the foregoing method is suitable for suppressing local temperature rise.

However, even when, as separate press-fit terminals, they are not integrally adhered to each other, the base portions 12 of the terminal are substantially integrated with each other when fixed in a semiconductor module; thus, by integrating (adhering) at least the regions of the front end portions 14 of the terminal units 10_{L}, an optimal press-fit terminal can be obtained.

### Variant Example of Embodiment 1

Furthermore, in the foregoing configuration, because press working or etching working makes it easier to perform working for the inner shape (the opening portion 15s) of the press-contact portion 15, the shape of the opening portion 15s can variously be changed in accordance with required characteristics. FIGS. 5 through 8 illustrate variant examples of the press-fit terminal according to Embodiment 1 of the present invention.

The shapes of the press-fit terminal 10ᵥ₁ through 10ᵥ₄ illustrated in FIGS. 5 through 8 have been designed for the purpose of strengthen the contact-pressure force exerted on the through-hole inner wall 31w after the press-fit terminal is pressed into the through-hole 31.

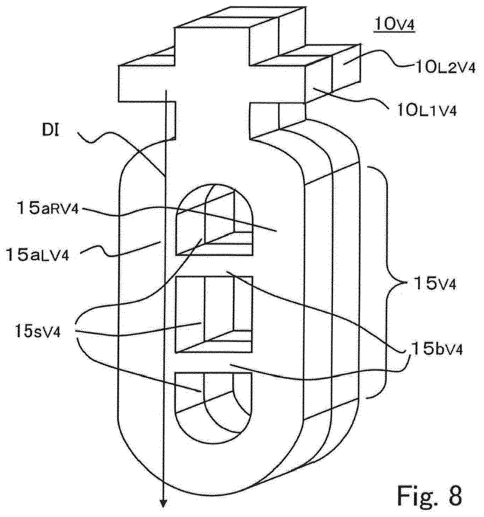

For example, in FIGS. 5 through 7, there are provided protrusion portions 15pᵥ₁ through 15pᵥ₃, respectively, for the purpose of pressing the press-contact portion from the inside when the press-fit terminal is press-fitted; alternatively, in FIG. 8, there is provided a support post 15bᵥ₄ for the purpose of supporting the press-contact portion 15ᵥ₄ before and when the press-fit terminal is press-fitted.

In the case where as one of the variant examples, among those, that are illustrated in FIGS. 5 through 7, each of the protrusion portions 15pᵥ₁ through 15pᵥ₃, which protrudes toward the opposite side face, is provided at each side of the branch portion 15a branched from the front end portion 14, the contact force, of each of the terminals 10ᵥ₁ through 10ᵥ₃, that is exerted on the through-hole 31, is strengthened when each of the press-fit terminals 10ᵥ₁ through 10ᵥ₃ is inserted into the wiring board through-hole 31 or the like.

In addition, because each of the press-contact portions 15ᵥ₁ through 15ᵥ₃ of the terminals 10ᵥ₁ through 10ᵥ₃ exerts contact force uniformly on the through-hole inner wall 31w, the contact area increases and the contact resistance decreases, so that a large current can flow.

Moreover, at the initial time of insertion, the inter-fulcrum distance can be extended; thus, even in the case of a soft material, insertion force can be reduced, whereby the press-fit terminal can normally be inserted without breaking the terminals 10ᵥ₁ through 10ᵥ₃ and the wiring board 30.

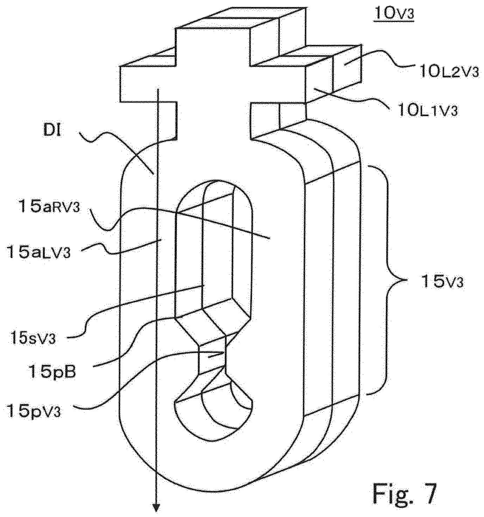

In the case where as illustrated in FIGS. 5 and 7, the protrusion portions 15pᵥ₁ and 15pᵥ₃ are formed in such a way that a root portion 15p_{B} extending from the side face thereof is in the shape of a taper, repulsive force is generated against the through-hole inner wall 31 even when the press-fit terminal 10ᵥ₁ (10ᵥ₃) is inserted into the through-hole 31 in an inclined manner.

The reason for the foregoing phenomenon is that although when the press-fit terminal 10ᵥ₁ (10ᵥ₃) is inserted into the through-hole 31 in an inclined manner, the protrusion portions 15pᵥ₁ (15pᵥ₃) partially collide with each other, the protrusion portion 15pᵥ₁ (15pᵥ₃) is suppressed from being deformed because the taper-shaped root portion 15p_{B} extending from the side face strengthens the bending strength of the protrusion portion 15pᵥ₁ (15pᵥ₃).

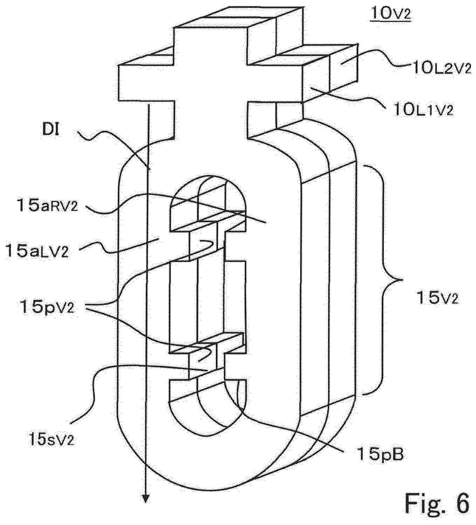

Therefore, even in the case where the press-fit terminal 10ᵥ₁ (10ᵥ₃) is inserted in an inclined manner, the protrusion portion 15pᵥ₁ (15pᵥ₃) can generate repulsive force against the through-hole inner wall 31w. In FIG. 6, the root portion 15p_{B} of the protrusion portion 15pᵥ₂ is not taper-shaped; however, by forming the root portion 15p_{B} in the shape of a taper, as is the case with FIG. 5 or 7, the same effect can be demonstrated.

In this regard, however, it is extremely difficult to create, directly from a single plate, a press-fit terminal having such an inner shape (of the opening portion) as described above. However, because a press-fit terminal according to the present invention has a structure in which a plurality of press-fit terminal units are laminated in the board-thickness direction, creation of each press-fit terminal unit is easy.

This method makes it easy to perform working for the press-fit shape and makes it possible to reduce the width of the opening portion; furthermore, because it is made possible to make the shape of the opening portion complex for the purpose of exerting required contact-pressure force, a terminal can be designed without any working restriction.

For example, in the press-fit terminals 10ᵥ₁ through 10ᵥ₃ illustrated in FIGS. 5 through 7, the widths of the opening portions 15sᵥ₁ through 15sᵥ₃ are narrowed at the protrusion portions 15pᵥ₁ through 15pᵥ₃, respectively; it is whether the gap of the portion where no protrusion portion (15pᵥ₁ through 15pᵥ₃) is provided is narrow or not that is important when working is implemented; thus, no problem is posed if the representative width, which is the widest spacing of the opening portion, is larger than the board thickness.

It may be allowed that the width of the branch portion 15a becomes narrower or wider within its span; in the case where the width of the branch portion 15a becomes narrower or wider within its span, the narrowest width is adopted as the representative width, and the representative width is made to be wider than the board thickness.

In addition, each of the foregoing figures illustrates the press-fit terminal 10 in the state where it is divided into two pieces in the board-thickness direction (y direction); however, it may be divided into three or more pieces. As the board thickness per layer of the divided press-fit terminal 10 is smaller, working for the shape of the press-fit terminal becomes easier; thus, even when the width of the opening portion is small, working can accurately be carried out; furthermore, the shape of the opening portion can be made complex, so that required contact-pressure force can be exerted.

Even when obtained through press working, the press-fit terminal unit having a small board thickness can maintain the flatness without any large warp; however, some burrs may be produced. In that case, by arranging the press-fit units in such a way that the directions in which burrs are produced are symmetric with each other with respect to the thickness (lamination) direction, a more homogenous press-fit terminal can be obtained.

As described above, the press-fit terminal 10 (and 10ᵥ₁ through 10ᵥ₄) according to Embodiment 1 of the present invention is a press-fit terminal that is pressed into the through-hole 31, as an electric contact, so that electric connection is established; the press-fit terminal 10 is made of a plate material and is configured by laminating in the thickness direction (y direction) a plurality of the press-fit units 10L including the front end portion 14 that is formed in the shape of an taper and the press-contact portion 15 that is formed in such a way to have a pair of portions 15a branched from the front end portion 14, and the respective side faces of the pair of portions 15a face each other through a predetermined spacing 15s, and that are inserted and pressed into the through-hole 31.

Accordingly, in comparison with a conventional case where a press-fit terminal is formed of a single unit, the board thickness of a working object becomes thinner; thus, working can readily and accurately be performed, and a press-fit terminal can be obtained that can reduce the contact resistance between the press-fit terminal and the female electrode without increasing the press-fitting force at a time when being press-fitted.

In particular, because each of the board thicknesses t_{L} of a plurality of the laminated press-fit terminal units 10_{L} is made thinner than the width Ws of the opening portion 15s or each of the widths Wa of the pair of portions 15a branched from the front end portion, the working for each press-fit terminal unit 10_{L} can readily and accurately be carried out; therefore, a press-fit terminal can be obtained that can reduce the contact resistance between the press-fit terminal and the female electrode without increasing the press-fitting force at a time when being press-fitted.

By making the total thickness tₒ of the press-fit terminal 10 configured by laminating the press-fit terminal units 10_{L} thicker than each of the widths Wa of the branch portions 15a, desirable press-fit characteristics can be realized.

Moreover, the laminated press-fit terminal units 10_{L} are adhered to each other at least at the region of the front end portion 14, so that the press-fit terminal unit 10_{L} of the outmost layer comes out of the through-hole 31 and hence the press-fit terminal can readily be press-fitted.

Furthermore, the laminated press-fit terminal units 10_{L} are separated from each other at least at the region of the press-contact portion 15, i.e., the laminated press-fit terminal units 10_{L} are not fixed to each other so that the respective branch portions 15a can separately be deformed; therefore, because large contact-pressure force can be obtained with small press-fitting force and the contact-pressure force exerted on the through-hole 31 can be suppressed from locally deviating, a damage to the through-hole 31 is diminished.

Moreover, in the case where each of the protrusion portions 15pᵥ₁ through 15pᵥ₃, which protrude toward the opposite side face, is provided at each side of the pair of portions 15a branched from the front end portion 14, the contact force, of each of the terminals 10ᵥ₁ through 10ᵥ₃, that is exerted on the through-hole 31, is strengthened when each of the press-fit terminals 10ᵥ₁ through 10ᵥ₃ is inserted into the wiring board through-hole 31 or the like.

In addition, because each of the press-contact portions 15ᵥ₁ through 15ᵥ₃ of the terminals 10ᵥ₁ through 10ᵥ₃ exerts contact force uniformly on the through-hole inner wall 31w, the contact area increases and the contact resistance decreases, so that a large current can flow.

Moreover, at the initial time of insertion, the inter-fulcrum distance can be extended; thus, even in the case of a soft material, insertion force can be reduced, whereby the press-fit terminal can normally be inserted without breaking the terminals 10ᵥ₁ through 10ᵥ₃ and the wiring board 30.

In the case where the protrusion portions 15pᵥ₁ and 15pᵥ₃ are formed in such a way that the root portion 15p_{B} extending from the side face thereof is in the shape of a taper, repulsive force is generated against the through-hole inner wall 31 even when the press-fit terminal 10ᵥ₁ (10ᵥ₃) is inserted into the through-hole 31 in an inclined manner.

The sizes of the press-fit terminal 10 and the through-hole 31 may be different from those described above; it is only necessary that at least the width (the present one is 2.2 mm) of the press-contact portion 15 of the press-fit terminal 10 is larger than the inner diameter (the present one is 2.0 mm) of the through-hole. The press-fit terminal unit is not limited to the flat one; bending working may be applied to the press-contact portion and the like.

It is allowed that the thickness of the copper wiring conductor 33 and the plating thickness thereof may be different from the foregoing values. Although an example has been described in which the press-fit terminal is pressed into a wiring board through-hole, Embodiment 1, described above, can be applied to a press-fit terminal that is pressed into the metal conductor or the like of a connector or the like.

### Embodiment 2

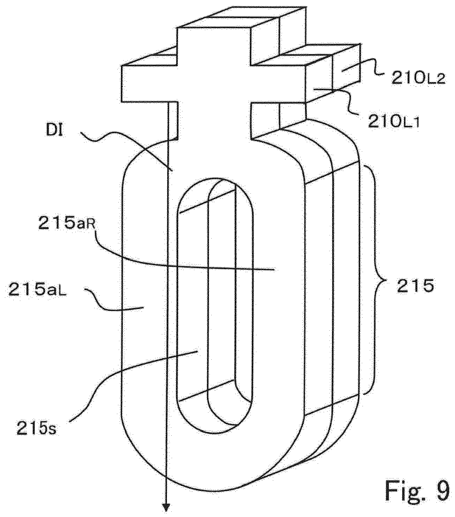

A press-fit terminal according to Embodiment 2 differs from a press-fit terminal according to Embodiment 1 in terms of the combination of materials for respective terminal units. FIG. 9 is a view illustrating a press-fit terminal 210 according to Embodiment 2. In FIG. 9, one press-fit-shaped terminal unit 210_{L1} is formed of a pure copper plate, and the other press-fit-shaped terminal unit 210_{L2} is formed of a phosphor bronze plate.

A press-fit terminal according to each Embodiments of the present invention has a structure in which a plurality of press-fit-shaped terminal units are laminated; therefore, the press-fit terminal 210, formed of different materials, can readily be configured. The other configurations are the same as those of the press-fit terminal described in Embodiment 1; therefore, the explanation therefor will be omitted.

When a large current flows, it is required to suppress heat generation in the terminal and at a contact position where the press-contact portion of the terminal and the through-hole inner wall make contact with each other. A high-conductivity material is required for the purpose of suppressing heat generation in the terminal.

For the purpose of suppressing heat generation in the contact position, it is required to enhance the force exerted on the press-contact portion so as to reduce the contact resistance. However, pure copper or the like, which is a high-conductivity material for suppressing heat generation in the terminal, is extremely soft and low-strength. In contrast, the conductivity of phosphor bronze, which has a high mechanical strength, is lower than that of copper. In other words, realistically, there exists no material that satisfies both of conductivity and mechanical strength.

Accordingly, when priority is given to the conductivity, plastic deformation is liable to occur and hence it is difficult to enhance the force exerted on the press-contact portion; in contrast, when priority is given to the mechanical strength, the conductivity is low; therefore, in either case, there has been a problem that because the resistance of the contact position becomes large and hence heat generation therein is extremely large, it is difficult to deal with a large current.

However, in the press-fit terminal 210 according to Embodiment 2, by forming the one press-fit-shaped terminal unit 210_{L1} with a high-conductivity material and forming the other press-fit-shaped thin-plate terminal unit 210_{L2} with a high-strength material, there can be satisfied both requirements, i.e., to raise the conductivity of the overall press-fit terminal 210 and to enhance the force exerted on a press-contact portion 215.

In addition, as a laminated body consisting of different materials, a clad material and the like have been known; however, because a clad material is already integrated when it is at the stage of a material and hence is equivalent to a single plate, working for the opening portion is still troublesome.

Furthermore, in the case of a clad material made of substances having different strengths, in press working of a small-dimensional portion such as the opening portion of a press-fit terminal, the high-strength material is distorted when the working is implemented, thereby deforming the low-strength material.

Thus, a clad material is not suitable because the press-fit terminal units cannot maintain their plate shape. In contrast, in the present invention, there has been adopted a structure in which thin plate materials, made in the shape of a press-fit, are laminated.

Therefore, there is demonstrated a merit that working for the opening portion is readily implemented and, unlike the above-mentioned case, the high-strength material does not deform the low-strength material.

As described above, in the press-fit terminal 210 according to Embodiment 2, plate materials (copper plate/phosphor bronze plate) having different substances are utilized for a plurality of press-fit terminal units 210_{L1} and 210_{L2}; therefore, there can be satisfied both requirements, i.e., to raise the conductivity of the overall press-fit terminal 210 and to enhance the force exerted on the press-contact portion 215.

### Embodiment 3

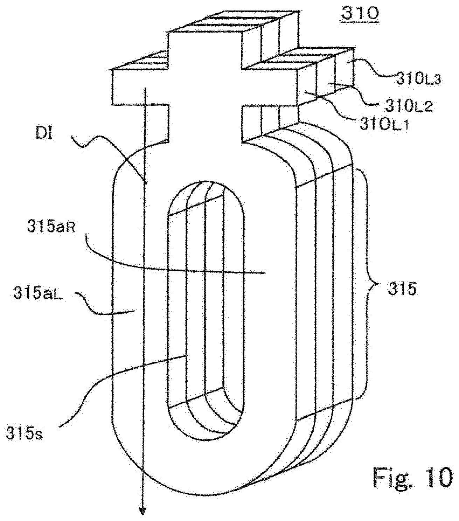

In a press-fit terminal according to Embodiment 3, the number of divisions is "3" or larger, and the materials of the outer-layer terminal units and the inner-layer terminal unit in the board-thickness direction are different from each other. FIG. 10 illustrates the configuration of a press-fit terminal 310 according to Embodiment 3 of the present invention. In FIG. 10, a press-fit terminal 310 is divided into three pieces in the board-thickness direction (y direction), and outmost thin plates 310_{L1} and 310_{L3} are made of a same material.

Each of the layers 310_{L1} and 310_{L3} and a layer 310_{L2} is 0.33 mm; the overall thickness of the press-fit terminal obtained by laminating the three plate materials is 1 mm. An example will be explained in which high-strength stainless steel is utilized as the material of middle-layer press-fit terminal unit 310_{L2} and high-conductivity pure copper is utilized as the material of the outmost-layer press-fit terminal units 310_{L1} and 310_{L3}.

In addition, the terminal units, which are the respective layers of the press-fit terminal, are integrated with one another. The other configurations than described above are almost the same as those explained in Embodiment 1; therefore, duplicated explanation therefor will be omitted.

The reason why the foregoing configuration has been adopted will be described below.

The linear-expansion coefficient of pure copper is approximately 17 ppm/K; however, the linear-expansion coefficient of stainless steel is approximately 14 ppm/K. When a press-fit terminal undergoes a high-temperature environment, the materials thereof thermally expand.

At that time, due to the difference between the linear-expansion coefficients of the materials, a thermal stress is caused at the interface between the one material and the other material, thereby causing a warp; however, by utilizing a same material for the outmost layers, a uniform thermal stress is caused in the interface between the one material and the other material that are symmetric with each other in the board-thickness direction when the temperature rises.

As a result, the overall terminal thermally expands without warping. Through the foregoing method, even at a high temperature, uniform contact-pressure force can be exerted to the contact position on the inner wall of the through-hole; thus, stable electric connection can be realized, whereby the temperature-cycle reliability can be raised.

In the press-fit terminal according to Embodiment 3, the number of divisions in the board-thickness direction may be "4" or larger. In that case, it is only necessary that the materials are arranged in symmetry with one another with respect to the center in the board-thickness direction.

As far as the foregoing configuration is concerned, a case has been described in which all the respective layers are integrated with one another; however, even in the case where the respective layers are partially integrated with one another in the press-in direction, i.e., in the case where only the front end portions or only the front end portions and the base portions are integrated with one another, the same effect can be demonstrated.

In some cases, use of different materials can also provide a suitable effect to a factor other than the temperature. For example, the press-contact portion of a press-fit terminal and a through-hole make contact with each other at the four corners of the terminal.

Accordingly, for example, the layer structure is configured with three (or more) layers, high-conductivity and soft pure copper is adopted as the material of the outmost-layer press-fit terminal, and a high-strength material is adopted as the material of the inner-layer press-fit-shaped terminal unit, so that when the terminal is pressed into a through-hole, the four corners of the terminal are contracted and deformed; thus, the contact area between the terminal and the through-hole increases.

On the other hand, when a high-mechanical-strength terminal unit is utilized as the inner layer, the inner-layer terminal unit plays a role of a mechanical support for the through-hole; thus, the terminal stabilizes mechanically and the outmost-layer press-fit terminal unit is not subjected to unnecessary stress. As a result, the contact resistance can be reduced.

Furthermore, because when the press-fit terminal is satisfactorily press-fitted, the press-contact portion thereof and the through-hole form diffusion bonding, further stronger connection can be realized, whereby the reliability in a thermal cycle or high-temperature retention is raised.

As described above, the press-fit terminal 310 according to Embodiment 3 of the present invention is configured in such a way that plate materials having the same substance are utilized for the press-fit terminal units (outmost-layer terminal units 310_{LE} or inner-layer terminal units 310_{I}), among a plurality of press-fit terminal units 310_{L}, that are situated evenly spaced apart from the center AC of the laminating direction.

Therefore, a uniform thermal stress is caused in the interface between the one material and the other material that are symmetric with each other in the laminating direction (board-thickness direction: y direction), even when the temperature changes; as a result, the overall warp of the press-fit terminal 310 is reduced and hence the reliability in connection is raised.

### Embodiment 4

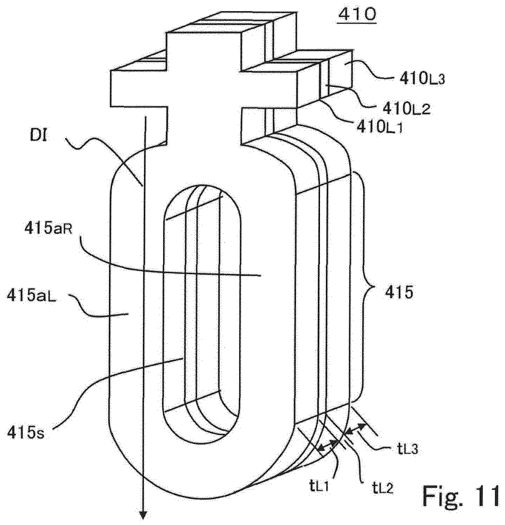

In a press-fit terminal according to Embodiment 4, the number of divisions is "3" or larger, and the thicknesses of the outer-layer terminal units and the inner-layer terminal unit in the board-thickness direction are different from each other. FIG. 11 illustrates the configuration of a press-fit terminal 410 according to Embodiment 4 of the present invention.

In FIG. 11, in the press-fit terminal 410 in which three press-fit terminal units (410_{L1} through 410_{L3}) are laminated, when the overall board thickness is set to 1 mm, the board thickness of a middle-layer press-fit unit 410_{L2} is set to 0.2 mm, the board thicknesses of outmost-layer press-fit terminal units 410_{L1} and 410_{L3} are each set to 0.4 mm, and the respective terminal units are adhered to one another so as to be integrated with one another.

As far as the materials of the respective terminal units are concerned, high-strength stainless steel is utilized as the material of middle-layer press-fit terminal unit 410_{L2} and high-conductivity pure copper is utilized as the material of the outmost-layer press-fit terminal units 410_{L1} and 410_{L3}. The other configurations are the same as those of the press-fit terminal described in each of Embodiments 1 through 3; therefore, the explanation therefor will be omitted.

The reason why the foregoing configuration has been adopted will be described below.

In the case where the press-fit terminal is configured in such a way as described above, when the overall board thickness is 1 mm, the conductivity of the overall terminal can be raised in comparison with the case where the board thicknesses of the respective terminal units are set to be the same as one another.

This is because in the press-fit terminals 410 according to Embodiment 4, the board thickness of the high-conductivity pure copper accounts for the four-fifths (0.8 mm) of the overall board thickness of the press-fit terminal 410; the overall conductivity of the terminal is raised by at least 80% in comparison with the case where the entire press-fit terminal is formed of pure copper.

Moreover, a material having a higher strength than pure copper is utilized for the middle-layer terminal unit 410_{L2}; therefore, even when the board thickness of the terminal unit is decreased to 20% (0.2 mm) of the overall board thickness, the contact pressure to the through-hole inner wall 31w can be maintained.

As a result, heat generation in the terminal can further be suppressed in comparison with the case where the respective materials having same board thickness are combined with one another, when a large current flows.

As a press-fit terminal according to Embodiment 4, an example where the number of divisions is "3" has been described; however, the number of divisions may be "4" or larger. It is only necessary that a corner portion 415c of at least the outmost-layer terminal unit in the thickness direction (y direction) makes contact with the through-hole inner wall 31w.

Therefore, in that case, it is only necessary that the width Wₒ of the press-contact portion of the press-fit terminal unit is larger than the chord of the through-hole inner wall 31w at the position of thickness-direction outer face of the press-fit terminal unit (410_{LE}).

As described above, in the press-fit terminal 410 according to Embodiment 4 of the present invention, materials having different thicknesses are utilized for a plurality of press-fit terminal units 410_{L}; therefore, the conductivity and the connection reliability can further be raised.

The press-fit terminal 410 according to Embodiment 4 of the present invention is configured in such a way that in particular, plate materials having same board thickness are utilized for the press-fit terminal units (outmost-layer terminal units 410_{LE} or inner-layer terminal units 410_{L1}, among a plurality of press-fit terminal units 4310_{L}, that are situated evenly spaced apart from the center AC of the laminating direction; therefore, even when the temperature changes, a warp is suppressed from being produced; thus, the conductivity and the connection reliability can further be raised.

### Embodiment 5

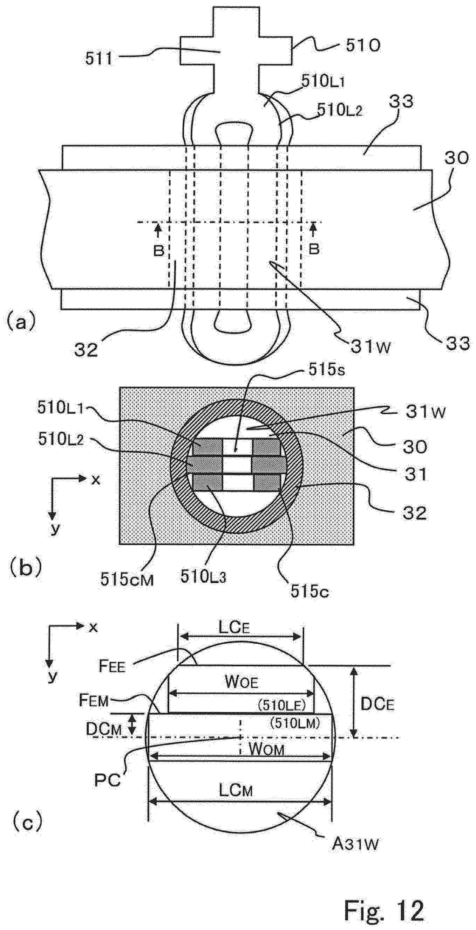

In a press-fit terminal according to Embodiment 5, the number of divisions is "3" or larger, and the press-fit shapes of the outer-layer terminal units and the inner-layer terminal unit in the board-thickness direction are different from each other. FIG. 12 illustrates the configuration of a press-fit terminal 510 according to Embodiment 5 of the present invention.

FIG. 12(a) is a side view at a time when the press-fit terminal 510 is pressed into a through-hole; FIG. 12(b) is a cross-sectional view taken along the line B-B in FIG. 12(a), i.e., a cross-sectional view at the center position in the thickness direction of the through-hole at a time when the press-fit terminal 510 has been pressed into the through-hole.

FIG. 12(c) is a diagram for explaining the dimensional relationship at a time before the press-fit terminal 510 is pressed into the through-hole. In FIG. 12, the press-fit terminal 510 is divided into three pieces in the board-thickness direction; the widths W_{OE} of the press-contact portions 515 of outmost-layer press-fit terminal units 510_{L1} and 510_{L3} (referred to as 510_{LE}, hereinafter) is smaller than the width W_{OM} of the press-contact portion 515 of a middle-layer press-fit terminal unit 510_{L2} (referred to as 510_{LM}, hereinafter).

The widths W_{OE} and W_{OM} of the press-contact portions of the terminal units are larger than the lengths LC_{E} and LC_{M} (lengths of the chords corresponding to the chord distances D_{CE} and D_{CM}), respectively, of the chords of an arcs A_{31w}, which are parts of a cross-sectional shape of the through-hole inner wall 31w, corresponding to the position of the outer side faces F_{EE} and F_{EM}.

In addition, the terminal units forming the respective layers of the press-fit terminal may be integrated either entirely or partially with one another. The other configurations than described above are almost the same as those of the press-fit terminal explained in each of Embodiments 1 through 4; therefore, the explanation therefor will be omitted.

The reason why the foregoing configuration has been adopted will be described below.

Through the foregoing method, the four corner portions 515c_{M} of the inner-layer terminal unit 510_{LM} in addition to the four corner portions 515c of the outmost-layer terminal units 510_{LE}, i.e., eight points of the press-fit terminal 510 make contact with the through-hole inner wall 31w; thus, the contact area can be enlarged.

Therefore, the resistance at the contact position can be reduced. As a result, when a large current flows, the temperature rise due to the heat generation at the contact position can be suppressed, whereby the long-term reliability is raised.

Furthermore, because of the increased contact points, the contact force of the press-contact portion 515 of the press-fit terminal 510 is exerted on a wider area of the through-hole inner wall 31w, even when external load is imposed on the right and left side of the bearing portion 511 of the press-fit terminal 510; therefore, neither the press-fit terminal 510 comes out nor the contact force is weakened.

For example, in the case where a press-fit terminal according to Embodiment 5 is utilized in a power semiconductor module, the thermal expansion of a utilized resin causes a thermal stress on the press-fit terminal and the through-hole inner wall; however, because of the increased contact points, the reliability is raised.

Moreover, by enlarging the contact area, the contact force exerted on a unit area of the contact portion is dispersed; thus, the load imposed on the plating of the through-hole inner wall 31w or the wiring board 30 can be reduced, whereby shaving or peeling of the plating and cracking or stress-whitening of the wiring board 30 can be suppressed. As a result, the reliability of the wiring board 30 and the connection portion is raised.

Also in a press-fit terminal according to Embodiment 5, the number of divisions may be larger than "3" illustrated in FIG. 12. Also in that case, it is only necessary that the width Wₒ of the press-contact portion of the press-fit terminal unit becomes smaller in the direction from the middle layer to the outmost layer.

As described above, the press-fit terminal 510 according to Embodiment 5 of the present invention is configured in such a way that a plurality of press-fit terminal units 510_{L} having different widths W_{O} of the press-contact portion 515 are utilized; therefore, the contact force and the contact area can freely be adjusted.

In particular, the width W_{O} of the press-contact portion 515 of the press-fit terminal unit 510_{L} becomes narrower as the position of that press-fit terminal unit 510_{L} is more apart from the center AC of the laminating direction (as the lamination position becomes more distal); therefore, the press-fit terminal units 510_{L} of the respective layers can separately make press-contact with the through-hole inner wall 31w, whereby satisfactory contact can be maintained.

### Embodiment 6

Also in a press-fit terminal according to Embodiment 6, as is the case with Embodiment 5, the number of divisions is "3" or larger, and the press-fit shapes of the outer-layer terminal units and the inner-layer terminal unit in the board-thickness direction are different from each other; however, in Embodiment 6, the width of the press-contact portion of an outer-layer terminal unit is made wider than the width of the press-contact portion of an inner-layer terminal unit.

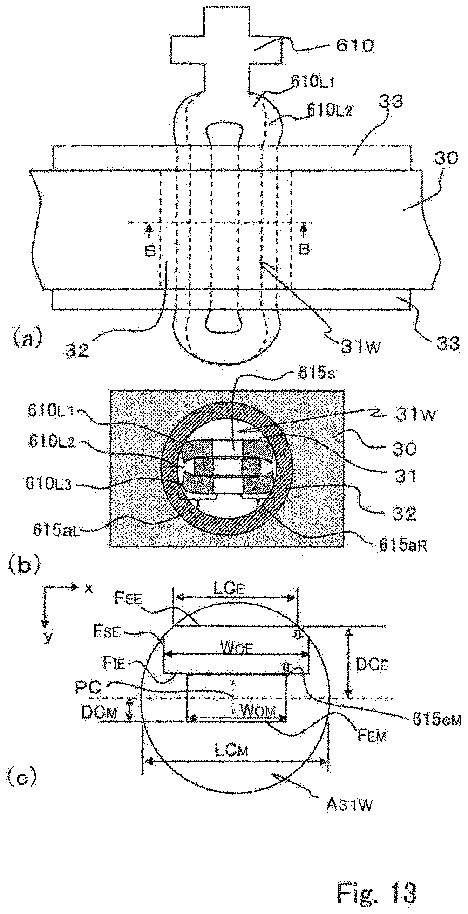

FIG. 13 illustrates the configuration of a press-fit terminal 610 according to Embodiment 6 of the present invention; FIG. 13(a) is a side view at a time when the press-fit terminal 610 is pressed into a through-hole; FIG. 13(b) is a cross-sectional view taken along the line B-B in FIG. 13(a), i.e., a cross-sectional view at the center position in the thickness direction of the through-hole at a time when the press-fit terminal 610 has been pressed into the through-hole.

FIG. 13(c) is a diagram for explaining the dimensional relationship at a time before the press-fit terminal 610 is pressed into the through-hole. In FIG. 13, the press-fit terminal 610 is divided into three pieces in the board-thickness direction; the widths W_{OE} of the press-contact portions 615 of outmost-layer press-fit terminal units 610_{L1} and 610_{L3} (referred to as 610_{LE}, hereinafter) are larger than the width W_{OM} of the press-contact portion 615 of a middle-layer press-fit terminal unit 610_{L2} (referred to as 610_{LM}, hereinafter).

The width W_{OE} of the press-contact portion of the outmost-layer press-fit terminal unit 610_{LE} is made larger than the length LC_{E} (corresponding to the chord distance D_{CE}, i.e., the length of the chord spaced apart from the center PC of the arc = the axis center AC by half of the thickness of the terminal 610) of the chord of an arc A_{31w}, which is part of a cross-sectional shape of the through-hole inner wall 31w, corresponding to the position of the outer side face F_{EE} of the outmost-layer press-fit terminal unit.

In contrast, the width W_{OM} of the press-contact portion of the inner-layer press-fit terminal unit 610_{LM} is smaller than the length LC_{M} of the chord of the arc A_{31w} corresponding to the position of the outer side face F_{EM} of the inner-layer press-fit terminal unit.

In addition, it is desirable that the terminal units forming the respective layers of the press-fit terminal are integrated with each other; however, it is allowed that they are not entirely integrated with each other. The other configurations than described above are almost the same as those of the press-fit terminal explained in each of Embodiments 1 through 5; therefore, the explanation therefor will be omitted.

The reason why the foregoing configuration has been adopted will be described below.

In the case of the press-fit terminal 610 according to Embodiment 6, the press-fit terminal unit 610_{L1}, which is the outmost layer in the board-thickness direction (Y direction), is deformed in the shape of a sector inward in the board-thickness direction along the through-hole inner wall 31w, when the press-fit terminal 610 is pressed into the through-hole 31w. Accordingly, the outer side face F_{EE} of the press-contact portion 615 of the press-fit terminal and the side face F_{SE} of the press-fit terminal make contact with the through-hole inner wall 31w.

Therefore, there is demonstrated an effect that the contact area between the press-fit terminal 610 and the through-hole inner wall 31w is enlarged. As a result, the contact resistance decreases, whereby the temperature rise due to the heat generation at the contact position, caused by a large current, can be suppressed.

In order to make the outmost-layer press-fit terminal unit 610_{LE} be deformed in the shape of a sector along the through-hole inner wall 31w, it is required that the width W_{OM} of the press-contact portion of the terminal unit (the inner-layer terminal unit 610_{LM}, in the case where as Embodiment 6, three layers are utilized) adjacent to the inner side of the outmost-layer terminal unit 610_{LE} is smaller than the length LC_{E} of the chord of the arc A_{31w} corresponding to the position of the outer side face F_{EE} of the outmost-layer press-fit terminal unit.

Thus, when the press-fit terminal 610 is pressed into the through-hole 31, the force, exerted from the inner wall 31W to the outer face F_{EE} of width-direction (x direction) both ends of the outmost-layer press-fit terminal unit 610_{LE}, is borne by the inner face F_{IE} of the both ends at the corner portions 615C_{M} of the inner-layer terminal unit 610_{LM}.

In other words, forces are exerted on different positions in the width direction on the opposing surfaces of the press-fit terminal unit 610_{LE}; therefore, the press-fit terminal unit 610_{LE} can readily be deformed in the thickness direction.

Furthermore, the following effects are demonstrated.

After the press-fit terminal 610 is press-fitted, the outmost-layer press-fit terminal unit 610_{LE} is deformed in a bending manner in the thickness direction (in the xy plane); therefore, the outmost-layer press-fit terminal unit 610_{LE} exerts the elastic force caused through the bending, as reaction force against the through-hole inner wall 31w.

Accordingly, a larger contact force can be exerted on the through-hole inner wall 31w. As a result, the contact resistance decreases, whereby the temperature rise due to the heat generation at the contact position, caused by a large current, can be suppressed.

For the purpose of more effectively demonstrating the effect of this structure, it is desirable to utilize a material having a high elastic modulus for the outmost-layer press-fit terminal unit 610_{LE} and a material having a low electric resistivity for the inner-layer press-fit terminal unit. Moreover, the contact area between the through-hole inner wall 31w and the press-fit terminal is large.

Furthermore, due to the contact-pressure force of the press-fit terminal 610 itself and the repulsive force caused through bending the outmost-layer press-fit terminal unit 610_{LE}, contact force is exerted on the through-hole inner wall 31w; thus, after being press-fitted, the press-fit terminal 610 endures larger horizontal force and vertical force. Therefore, a high-reliability contact portion can be obtained.

As described above, the press-fit terminal 610 according to Embodiment 6 of the present invention is configured in such a way that assuming that the cross-sectional shape of the through-hole inner wall 31w is the arc A_{31w}, the width W_{OE} of the press-contact portion 615 of the press-fit terminal unit 610_{LE}, among the press-fit terminal units 610_{L}, that is the outmost layer in the laminating direction is wider than the length L_{CE} of the chord, of the arc A_{31w}, that is spaced apart from the center PC of the circle by half of the thickness tₒ of the press-fit terminal 610, and the width W_{OM} of the press-contact portion 615 of the press-fit terminal unit 610_{LM} that is adjacent to the inner side of the outmost-layer press-fit terminal unit 610_{LE} is narrower than the length L_{CE} of the chord; therefore, the outer face F_{EE} of the outmost-layer press-fit terminal unit is deformed in the shape of a sector along the inner wall 31w and can make contact with the inner wall 31w in a wide area.

### Embodiment 7

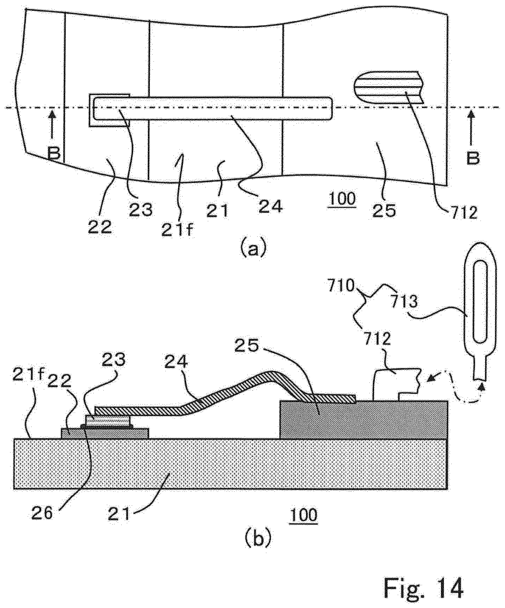

In Embodiment 7, a power semiconductor module utilizing one of the press-fit terminals explained in Embodiments 1 through 6 will be explained. FIGS. 14 through 16 are views for explaining the configurations of power semiconductor modules according to Embodiment 7 of the present invention; FIG. 14 is a set of partial plan view (FIG. 14(a)) and partial cross-sectional view (FIG. 14(b)) for explaining the internal structure of a power semiconductor module.

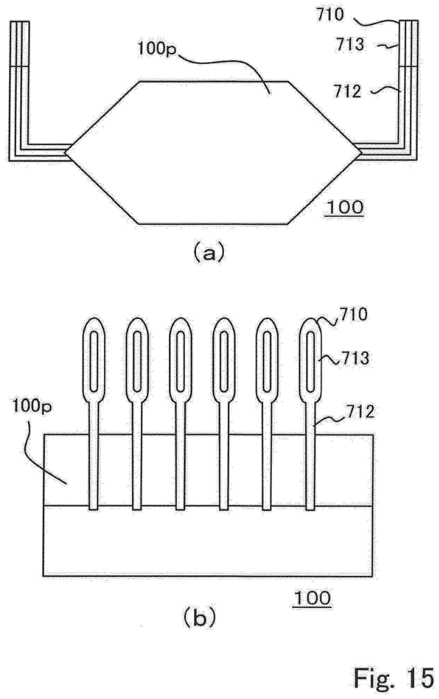

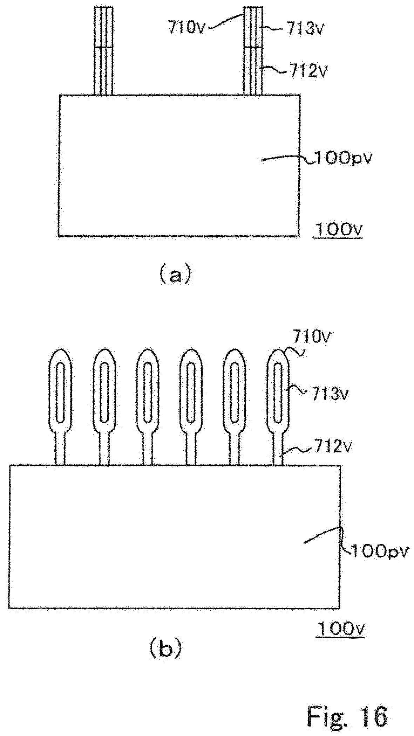

FIG. 15 is a set of elevation view (FIG. 15(a)) and side view (FIG. 15(b)) for explaining the appearance of a power semiconductor module; FIG. 16 is a set of elevation view (FIG. 16(a)) and side view (FIG. 16(b)) for explaining the appearance of a variant example of power semiconductor module. In addition, in FIGS. 14 through 16, the press-fit terminal is designated by 710 or 710ᵥ; however, any one of the press-fit terminals 10, 10ᵥ₁ through 10ᵥ₅, 110, 210, 310, 410, 510, and 610 may be utilized.

As illustrated in FIG. 14, in a power semiconductor module 100, there are arranged a circuit strip conductor 22 and an electrode plate 25 bonded by an unillustrated brazing filler metal or the like to a circuit side 21f of an insulated substrate 21, which is formed of a ceramic material such as aluminum nitride, silicon nitride, or alumina. The circuit strip conductor 22 and the electrode plate 25 are formed of a conductive material such as copper or aluminum, or an alloy material made mainly of copper and aluminum.

Moreover, taking the prevention of oxidation and the wettability of a soldering material into consideration, plating films are formed on the circuit strip conductor 22 and the electrode plate 25. Although unillustrated, a heat sink is formed on the other side of the circuit side 21f of the insulated substrate 21.

In FIG. 14, a semiconductor device 23 is connected with the circuit strip conductor 22 by the intermediary of solder 26. The semiconductor device 23 is formed of silicon carbide out of so-called wide bandgap semiconductor materials, such as silicon carbide (SiC), gallium nitride (GaN), and diamond, that have a bandgap wider than that of silicon; as the kind of semiconductor devices, the semiconductor device 23 is a switching device such as an IGBT (Insulated Gate Bipolar Transistor) or a MOSFET (Metal Oxide Semiconductor Field Effect Transistor) or a rectifying device such as a diode.

A drain electrode is formed on the side, of the semiconductor device 23, that faces the circuit strip conductor 22. In practice, a gate electrode and a source electrode are formed in separated regions on the side (the upper side of the semiconductor device 23 in FIG. 14), of the semiconductor device 23, that is opposite to the drain electrode.

However, for the easier understanding of the characteristics of Embodiment 7 of the present invention, explanation will be made assuming that on the upper side, only the source electrode is formed in which a large current flows. On the surface of the drain electrode, there is formed an alloy layer for satisfactorily bonding the drain electrode to the solder 26. Also on the surface of the source electrode, there is formed an unillustrated aluminum base layer having a thickness of several micrometers.

A lead 24 connects the semiconductor device 23 with the electrode plate 25 on the circuit side 21f. A bearing portion 711 (unillustrated) of a press-fit terminal 710 is fixed on the electrode plate 25; a press-fit portion 713 is derived from a base portion 712. As a result, a power supply path from the semiconductor device 23 (source electrode) to the external circuit is formed.

By covering such an internal structure as described above with a resin and packaging it, a transfer-type power semiconductor module 100, as illustrated in FIG. 15, is obtained. The transfer-type power semiconductor module 100 is configured in such a way that the press-fit terminals 710 are exposed from both sides of the package case 100p. In conventional cases, not the press-fit terminal 710 but a pin terminal has been exposed, and the connection between the pin terminal and an unillustrated through-hole of a wiring board has been made by soldering.

The cross-sectional area of a pin terminal through which a large current flows is large and the heat capacity thereof is also large; therefore, a conventional pin terminal has a problem that soldering connection through a flow soldering method is difficult to implement.

Therefore, there has been a problem that manual soldering by a skilled worker causes a cost hike. In particular, because a high-functionality power semiconductor module has a great number of pins, there has been a problem that connection thereof through manual soldering causes a significant cost hike.

In contrast, the power semiconductor module 100 utilizing the press-fit terminal 710 according to the present invention does not require to heat and melt solder, and is capable of being readily connected with a wiring board at room temperature by means of a hand press and a jig; thus, there is demonstrated an effect that the productivity is raised in comparison with a semiconductor module utilizing conventional pins for soldering.

### Variant Example of Embodiment 7

FIG. 16 is a view for a semiconductor module according to a variant example of Embodiment 7; the semiconductor module is a case-type power semiconductor module 100ᵥ. The case-type power semiconductor module 100v is configured in such a way that press-fit terminals 710ᵥ are exposed from top side of the package case 100pᵥ.

In this structure, unlike a transfer-type power semiconductor module, it is not required to bend the press-fit terminals (the base portions 712) because the press-fit terminals 710ᵥ come out from the top side of the case 100pv; therefore, there is demonstrated a merit that the positioning accuracy at a time when the press-fit terminal is pressed into a through-hole of the wiring board is improved.

Furthermore, because it is not required to bend the press-fit terminal, the press-fit terminal can readily be stood, and because soldering is not required, the distance between the neighboring pins can be diminished; as a result, the power semiconductor module can be downsized.

In the foregoing configuration, there has been described an example where the lead frame and the press-fit terminal are connected with each other by the intermediary of the electrode plate; however, the lead frame and the press-fit terminal may directly be connected with each other. In this case, the press-fit terminal is formed of laminated materials made of different substances and is combined with a lead frame of a single material made of copper, so that the press-fit terminal and the lead frame can be connected with each other through wire bonding or ultrasonic bonding.

Thus, because it is made possible that only the press-fit terminal is formed of laminated materials, the heat of the semiconductor device, which generates the largest heat in the module, can efficiently be radiated into the lead frame. As a result, there can be suppressed the temperature rise at a time when the semiconductor device generates heat.

In addition, it is also made possible that a press-fit terminal and a lead frame are integrated with each other and the lead frame has laminated layers. As a result, because the respective thicknesses of the plates into which the lead frame is divided become small, the lead frame shape can readily be produced through press working. Through the foregoing method, there is demonstrated an effect that because no high-accuracy and complex press die needs to be produced, the cost is decreased.

Furthermore, in the case where the board thickness is 1 mm, the width of the lead frame needs to be 1mm or larger; however, in the case where the plates having a board thickness of 0.5 mm are laminated so as to make the overall board thickness to be 1 mm, the width of the lead frame can be narrowed to 0.5 mm; thus, because the total size of the lead frame can be reduced, the module is downsized.

Moreover, the chip-mounting side of the laminated lead frame is made of copper and the other side thereof is made of a material, such as kovar or invar, that has a linear-expansion coefficient lower than that of copper, so that the copper can be suppressed from contracting in the temperature cycle. Through the foregoing method, the reliability in the temperature cycle can be raised.

Although in Embodiment 7, there has been described a case where the semiconductor device 23, which functions as a switching device (transistor) or a rectifying device (diode), is formed of silicon carbide, the present invention is not limited thereto; the semiconductor device 23 may be formed of silicon (Si), which is commonly used.

However, as described below, by utilizing silicon carbide, a gallium-nitride-system material, or a diamond that can form a so-called wide bandgap semiconductor, which has a bandgap larger than that of a semiconductor that is formed of silicon, the effect of the present invention can further be demonstrated.

When the power semiconductor module 100 is driven, current flows in various devices including the semiconductor device 23 in the power semiconductor module 100 are energized; in this situation, power loss in the electric resistance is converted into heat and hence the temperature inside the power semiconductor module 100 varies.

In this case, because the power loss in the switching device or the rectifying device (the semiconductor device 23 in each of Embodiments) formed of a wide bandgap semiconductor is smaller than the power loss in the device formed of silicon, the efficiency of the switching device and the rectifying device can be raised and eventually, the efficiency of the power semiconductor module can be enhanced.

Furthermore, because of a high withstand voltage and a high allowable current density, the switching device and the rectifying device can be downsized; by use of these downsized switching device and rectifying device, the power semiconductor module can also be downsized.

Moreover, because of a high heat resistance, the switching device and the rectifying device can be operated at a high temperature, and hence it is made possible to downsize the radiating fins of the heat sink and to replace water cooling by air cooling, whereby the power semiconductor module can further be downsized.

On the other hand, as described above, in the case of high-temperature operation, the difference between the temperature at a time when the power semiconductor module is off and the temperature at a time when the semiconductor module is being driven becomes large; furthermore, high efficiency and downsizing makes a current per volume larger. Accordingly, the temperature change with time and the spatial temperature gradient become large, whereby the highest reaching temperature and the temperature change amount may become large.

In the case of the foregoing power semiconductor module, the temperature of the electrode connection portion between the power semiconductor module and the wiring board becomes high; because conventional connection through soldering restricts large-current operation with which the temperature of the electrode connection portion becomes higher than the melting point of the solder, the ability of the semiconductor device cannot sufficiently be derived.

However, by use of a press-fit terminal according to each of Embodiments of the present invention, it is made possible to operate a semiconductor at a high temperature, without being subject to the restriction of the melting point of the solder.

Moreover, because in the case of a press-fit terminal according to the present invention, the connection area of the electrode is small in comparison with soldering, the thermal resistance between the press-fit terminal and the through-hole inner wall becomes large and hence the heat transfer from the semiconductor to the substrate can be suppressed; as a result, it is difficult for the heat of the semiconductor module to be transferred to the wiring board.

Therefore, even when the temperature of the semiconductor module becomes high, the temperature of the wiring board becomes unlikely to rise and hence the reliability of the wiring board is raised.

When a press-fit terminal according to each of Embodiments of the present invention is utilized, the press-fit terminal is securely held in a through-hole of the wiring board; thus, even when displacement is caused by a temperature change, the connection portion is not deformed and hence the connection reliability can be maintained.

In other words, by taking advantage of a wide bandgap semiconductor, it is made possible to obtain a high-reliability power semiconductor module even when the size is diminished or the efficiency is raised. That is to say, by exerting an effect of the present invention, the characteristics of a wide bandgap semiconductor can be utilized.

Moreover, a lead frame and a press-fit terminal are integrated with each other, the chip-mounting side of the laminated lead frame is made of copper, and the other side thereof is made of a material, such as kovar or invar, that has a linear-expansion coefficient lower than that of copper; as a result, the copper can be suppressed from contracting in the temperature cycle. Through the foregoing method, the reliability in the temperature cycle can be raised.

By connecting, for example, through wire bonding or ultrasonic bonding a press-fit terminal in which different materials are laminated with a lead frame made of a single material (copper), it is made possible to make only the press-fit have a laminated structure; thus, the heat of the semiconductor device, which generates the largest heat in the power semiconductor module, can efficiently be radiated into the lead frame. As a result, there can be suppressed the temperature rise at a time when the semiconductor device generates heat, whereby the reliability is raised.

In addition, a power semiconductor module according to Embodiment 7 has been explained with an example utilizing a circuit board in which the circuit strip conductor 22 is formed on the insulated substrate 21 made of a ceramic material; however, the present invention is not limited thereto.

For example, also in the case of a power semiconductor module utilizing a circuit board that is a so-called metal-based board and in which under circuit strip conductors, there is provided an insulating layer that is filled with a filler of an inorganic oxide or a nitride such as alumina or BN or a nitride for providing heat conductivity to a resin material such as an epoxy resin, or utilizing a circuit board to which an insulating sheet, made of a material the same as that of the insulating layer, is adhered, there can be obtained the same effect.

### Description of Reference Numerals

- 10: press-fit terminal
- 11: bearing portion
- 12: base portion
- 13: press-fit portion
- 14: front end portion
- 15: press-contact portion
- 15a: branch portion
- 15p: protrusion portion
- 15p_{B}: root portion of protrusion
- 15s: opening portion (gap))
- 16: tapered portion at terminal base side
- 17: front end portion (tapered portion at terminal front-end side)
- 30: wiring board
- 31: through-hole (penetrated hollow, 31w: through-hole inner wall)
- 33: wiring strip conductor
- 100: power semiconductor module (lOOp: case)
- 21: insulated substrate (21f: circuit side)
- 22: circuit strip conductor
- 23: semiconductor device
- 24: lead
- 25: electrode plate
- AC: center axis of press-fit terminal
- DI: press-fit terminal press-in direction
- A_{31w}: arc shape of through-hole inner wall
- DC: distance of chord
- F_{E}: outer side face
- LC: length of chord
- PC: center of arc of through-hole inner wall
- t: thickness
- Wa: width of branch portion
- W_{O}: width of press-contact portion
- Wₛ: width of opening portion

### Subscript:

- L: press-fit terminal unit,
- O: overall terminal,
- V: variant example Three-digit numbers denote respective Embodiments.

## Claims

1. A press-fit terminal (10) that is adapted to be pressed into a through-hole for electrical contact so as to perform electrical connection, the press-fit terminal being configured in such a way that there are laminated in a thickness direction a plurality of press-fit terminal units (10_{L}), each of which is made of a plate material and includes a front end portion (14) formed in the shape of a taper and press-contact portion (15) that is formed in such a way as to have a pair of portions (15a) branched from the front end portion (14) and in such a way that the respective side faces of the pair of portions (15a) face each other through a predetermined spacing (15s), and that is adapted to be inserted and pressed into the through-hole (31), wherein respective board thicknesses (t_{L}) of the plurality of press-fit terminal units (10_{L}) are smaller than width (Ws) of the predetermined spacing (15s) or respective widths (Wa) of the pair of portions (15a) branched from the front end portion (14),
**characterised in that**:
the laminated press-fit terminal units (10_{L}) are adhered to and integrated with each other at least in part of the regions thereof.

2. The press-fit terminal (10) according to claim 1,
wherein the board thickness (to) of the press-fit terminal (10) is larger than the respective widths (Wa) of the pair of portions (15a) branched from the front end portion (14).

3. The press-fit terminal (10) according to any one of claims 1 to 2,
wherein the laminated press-fit terminal units (10_{L}) are adhered to and integrated with each other at least in the region of the front end portion (14).

4. The press-fit terminal (10) according to any one of claims 1 to 2,
wherein the laminated press-fit terminal units (10_{L}) are adhered to and integrated with each other at least in the region of a base portion (12).

5. The press-fit terminal (10) according to any one of claims 1 to 2,
wherein the laminated press-fit terminal units (10_{L}) are adhered to and integrated with each other at least in the region of the front end portion (14) and a base portion (12).

6. The press-fit terminal (10) according to any one of claims 1 to 5,
wherein the laminated press-fit terminal units (10_{L}) are separated from each other at least in the region of the press-contact portion (15).

7. The press-fit terminal (210) according to any one of claims 1 to 6, wherein the plurality of press-fit terminal units (210_{L}) are formed of respective different plate materials.

8. The press-fit terminal (310) according to claim 7,
wherein the press-fit terminal units (310_{LE}), among the plurality of press-fit terminal units (310_{L}), that are situated at positions apart from the center in the laminating direction by a same distance are made of a same plate material.

9. The press-fit terminal (410) according to any one of claims 1 to 8,
wherein the plurality of press-fit terminal units (410_{L}) are formed of respective plate materials having different thicknesses.

10. The press-fit terminal (410) according to claim 9,
wherein the press-fit terminal units (410_{LE}), among the plurality of press-fit terminal units (410_{L}), that are situated at positions apart from the center in the laminating direction by a same distance are made of respective plate materials having same thickness.

11. The press-fit terminal (510) according to any one of claims 1 to 10, wherein the plurality of press-fit terminal units (510_{L}) are different from each other in the width (Wₒ) of the press-contact portion (515).

12. The press-fit terminal (510) according to claim 11,
wherein the width (Wₒ) of the press-contact portion (515) of the press-fit terminal unit (510_{L}) becomes narrower, as the position of said press-fit terminal unit (510) is more apart from the center in the laminating direction.

13. The press-fit terminal (610) according to claim 11,
wherein assuming that the cross-sectional shape of the through-hole inner wall (31W) is an arc, the width (W_{OE}) of the press-contact portion (615) of the press-fit terminal unit (610_{LE}), among the press-fit terminal units (610_{L}), that is the outmost layer in the laminating direction is wider than the length (LC_{E}) of the chord, of the arc, that is spaced apart from the center of the circle by half of the thickness of said press-fit terminal (610), and the width (W_{OM}) of the press-contact portion (615) of the press-fit terminal unit (610_{LM}) that is adjacent to the inner side of the outmost-layer press-fit terminal unit (610_{L}) is narrower than the length (LC_{E}) of the chord.

14. The press-fit terminal (10ᵥ₁ - 10ᵥ₄) according to any one of claims 1 to 13, wherein on the respective side faces of the pair of portions (15a) branched from the front end portion (14), protrusion portions (15pᵥ₁ - 15pᵥ₄) that protrude toward the respective opposite side faces are formed.

15. The press-fit terminal (10ᵥ₁, 10ᵥ₃) according to claim 14,
wherein the protrusion portions (15pᵥ₁, 15pᵥ₃) are formed in such a way that the respective root portions (15p_{B}) thereof extending from the side faces are in the shape of a taper.

16. A semiconductor module (100) comprising:
- a semiconductor device (23) mounted on a circuit strip conductor (22) formed on a circuit board (21); and
- the press-fit terminal (710) according to any one of claims 1 to 15,
the other end portion (711) of which, opposite to the front end portion, is electrically connected with the electrode of the semiconductor device (23).

17. The semiconductor module (100) according to claim 16,
wherein the semiconductor device (23) is formed of a wide bandgap semiconductor material.

18. The semiconductor module (100) according to claim 17,
wherein the wide bandgap semiconductor material is any one of a silicon carbide, a gallium nitride, and a diamond.

## Patentansprüche

1. Presspassungs-Anschluss (10), der dazu ausgebildet ist, für einen elektrischen Kontakt derart in ein Durchgangsloch gepresst zu werden, dass eine elektrische Verbindung hergestellt wird, wobei der Presspassungs-Anschluss derart ausgebildet ist, dass in Dickenrichtung eine Vielzahl von Presspassungs-Anschlusseinheiten (10_{L}) gestapelt sind, wobei jede von diesen aus einem Plattenmaterial hergestellt ist und einen vorderen Endbereich (14) und einen Presskontaktbereich (15) aufweist, wobei der vordere Endbereich (14) eine sich verjüngende Form aufweist und wobei der Presskontaktbereich (15) derart ausgebildet ist, dass er ein Paar von Bereichen (15a) aufweist, die von dem vorderen Endbereich (14) so abzweigen, dass die entsprechenden Seitenflächen des Paares von Bereichen (15a) einander mit einen vorbestimmten Abstand (15s) gegenüberliegen, und wobei der Presskontaktbereich (15) dazu ausgebildet ist, in das Durchgangsloch (31) eingesetzt und gepresst zu werden, wobei die jeweiligen Plattendicken (t_{L}) der Vielzahl von Presspassungs-Anschlusseinheiten (10_{L}) geringer sind als die Breite (Ws) des vorbestimmten Abstands (15s) oder die entsprechenden Breiten (Wa) des Paares von Bereichen (15a), die von dem vorderen Endbereich (14) aus abzweigen,
**dadurch gekennzeichnet,**
**dass** die geschichteten Presspassungs-Anschlusseinheiten (10_{L}) aneinander haften und miteinander integriert sind, und zwar zumindest in einem Teil der Bereiche hiervon.

2. Presspassungs-Anschluss (10) gemäß Anspruch 1,
wobei die Plattendicke (to) des Presspassungs-Anschlusses (10) größer ist als die entsprechenden Breiten (Wa) des Paares von Bereichen (15a), die von dem vorderen Endbereich (14) aus abzweigen.

3. Presspassungs-Anschluss (10) gemäß einem der Ansprüche 1 bis 2,
wobei die geschichteten Presspassungs-Anschlusseinheiten (10_{L}) zumindest in dem Bereich des vorderen Endbereichs (14) aneinander haften und miteinander integriert sind.

4. Presspassungs-Anschluss (10) gemäß einem der Ansprüche 1 bis 2,
wobei die geschichteten Presspassungs-Anschlusseinheiten (10_{L}) zumindest in dem Bereich eines Basisbereichs (12) aneinander haften und miteinander integriert sind.

5. Presspassungs-Anschluss (10) gemäß einem der Ansprüche 1 bis 2,
wobei die geschichteten Presspassungs-Anschlusseinheiten (10_{L}) zumindest in dem Bereich des vorderen Endbereichs (14) und eines Basisbereichs (12) aneinander haften und miteinander integriert sind.

6. Presspassungs-Anschluss (10) gemäß einem der Ansprüche 1 bis 5,
wobei die geschichteten Presspassungs-Anschlusseinheiten (10_{L}) zumindest in dem Bereich des Presskontaktbereichs (15) voneinander getrennt sind.

7. Presspassungs-Anschluss (210) gemäß einem der Ansprüche 1 bis 6,
wobei die Vielzahl von Presspassungs-Anschlusseinheiten (210_{L}) aus jeweiligen unterschiedlichen Plattenmaterialien ausgebildet sind.

8. Presspassungs-Anschluss (310) gemäß Anspruch 7,
wobei die Presspassungs-Anschlusseinheiten (310_{LE}) von der Vielzahl von Presspassungs-Anschlusseinheiten (310_{L}), die in einem gleichen Abstand an Positionen beabstandet von dem Zentrum in der Schichtrichtung angeordnet sind, aus dem gleichen Plattenmaterial hergestellt sind.

9. Presspassungs-Anschluss (410) gemäß einem der Ansprüche 1 bis 8,
wobei die Vielzahl von Presspassungs-Anschlusseinheiten (410_{L}) aus jeweiligen Plattenmaterialien ausgebildet sind, die unterschiedliche Dicken aufweisen.

10. Presspassungs-Anschluss (410) gemäß Anspruch 9,
wobei die Presspassungs-Anschlusseinheiten (410_{LE}) von der Vielzahl von Presspassungs-Anschlusseinheiten (410_{L}), die in einem gleichen Abstand an Positionen beabstandet von dem Zentrum in der Schichtrichtung angeordnet sind, aus jeweiligen Plattenmaterialien hergestellt sind, die die gleiche Dicke aufweisen.

11. Presspassungs-Anschluss (510) gemäß einem der Ansprüche 1 bis 10,
wobei die Vielzahl von Presspassungs-Anschlusseinheiten (510_{L}) sich in der Breite (Wo) des Presskontaktbereichs (515) voneinander unterscheiden.

12. Presspassungs-Anschluss (510) gemäß Anspruch 11,
wobei die Breite (Wo) des Presskontaktbereichs (515) der Presspassungs-Anschlusseinheit (510_{L}) schmaler wird, wenn die Position der Presspassungs-Anschlusseinheit (510) in Schichtrichtung weiter von dem Zentrum beabstandet ist.

13. Presspassungs-Anschluss (610) gemäß Anspruch 11,
wobei unter der Annahme, dass die Querschnittsform der inneren Wand (31W) des Durchgangslochs ein Bogen ist, die Breite (W_{OE}) des Presskontaktbereichs (615) der Presspassungs-Anschlusseinheit (610_{LE}) von den Presspassungs-Anschlusseinheiten (610_{L}), die die äußerste Lage in der Schichtrichtung ist, breiter ist als die Länge (LC_{E}) der Sehne des Bogens, der von dem Zentrum des Kreises um die Hälfte der Dicke des Presspassungs-Anschlusses (610) beabstandet ist, und wobei die Breite (W_{OM}) des Presskontaktbereichs (615) der Presspassungs-Anschlusseinheit (610_{LM}), die an die innere Seite der Presspassungs-Anschlusseinheit (610_{L}) der äußersten Lage angrenzt, schmaler ist als die Länge (LC_{E}) der Sehne.

14. Presspassungs-Anschluss (10_{V1} bis 10_{V4}) gemäß einem der Ansprüche 1 bis 13, wobei an den entsprechenden Seitenflächen des Paares von Bereichen (15a), die von dem vorderen Endbereich (14) aus abzweigen, vorstehende Bereiche (15p_{V1} bis 15p_{V4}) ausgebildet sind, die in Richtung der entsprechenden gegenüberliegenden Seitenflächen vorstehen.

15. Presspassungs-Anschluss (10_{V1}, 10_{V3}) gemäß Anspruch 14,
wobei die vorstehenden Bereiche (15p_{V1}, 15p_{V3}) derart ausgebildet sind, dass die jeweiligen Wurzelbereiche (15p_{B}) hiervon, die sich von den Seitenflächen aus erstrecken, sich verjüngend sind.

16. Halbleitermodul (100), das Folgendes aufweist:
- eine Halbleitervorrichtung (23), die an einer Schaltungs-Leiterbahn (22) montiert ist, die auf einer Leiterplatte (21) ausgebildet ist; und
- den Presspassungs-Anschluss (710) gemäß einem der Ansprüche 1 bis 15,
wobei der andere Endbereich (711) von diesem, der dem vorderen Endbereich gegenüberliegt, elektrisch mit der Elektrode der Halbleitervorrichtung (23) verbunden ist.

17. Halbleitermodul (100) gemäß Anspruch 16,
wobei die Halbleitervorrichtung (23) aus einem Halbleitermaterial mit großer Bandlücke hergestellt ist.

18. Halbleitermodul (100) gemäß Anspruch 17,
wobei das Halbleitermaterial mit großer Bandlücke eines der folgenden Materialien ist: Siliciumcarbid, Galliumnitrid und Diamant.

## Revendications

1. Borne engagée à la presse (10) qui est adaptée à être pressée dans un trou traversant pour contact électrique de manière à effectuer une connexion électrique, la borne engagée à la presse étant configurée d'une manière telle qu'une pluralité d'unités à borne engagées à la presse (10_{L}) sont stratifiées dans une direction en épaisseur, chacune de ces unités étant réalisée en un matériau en plaque et incluant une portion d'extrémité frontale (14) formée sous une forme effilée et une portion de contact à la presse (15) qui est formée d'une manière telle qu'elle comprend une paire de portions (15a) ramifiées depuis la portion d'extrémité frontale (14) et d'une manière telle que les faces latérales respectives de la paire de portions (15a) se font mutuellement face à travers un écartement prédéterminé (15s), et qui est adapté à être insérée et pressée dans le trou traversant (31), dans laquelle les épaisseurs de plaque respectives (t_{L}) de la pluralité d'unités à borne engagées à la presse (10_{L}) sont plus petites que la largeur (Ws) de l'écartement prédéterminé (15s) ou que les largeurs respectives (Wa) de la paire de portions (15a) ramifiées depuis la portion d'extrémité frontale (14), **caractérisée en ce que**
les unités à borne engagées à la presse (10_{L}) stratifiées sont adhérées et intégrées les unes aux autres au moins dans une partie de leurs régions.

2. Borne engagée à la presse (10) selon la revendication 1,
dans laquelle l'épaisseur de plaque (to) de la borne engagée à la presse (10) et plus grande que les largeurs respectives (Wa) de la paire de portions (15a) ramifiées depuis la portion d'extrémité frontale (14).

3. Borne engagée à la presse (10)
selon l'une quelconque des revendications 1 et 2,
dans laquelle les unités à borne engagées à la presse (10_{L}) stratifiées sont adhérées et intégrées les unes aux autres au moins dans la région de la portion d'extrémité frontale (14).

4. Borne engagée à la presse (10)
selon l'une quelconque des revendications 1 et 2,
dans laquelle les unités à borne engagée à la presse (10_{L}) stratifiées sont adhérées et intégrées les unes aux autres au moins dans la région d'une portion de base (12).

5. Borne engagée à la presse (10)
selon l'une quelconque des revendications 1 et 2,
dans laquelle les unités à borne engagées à la presse (10_{L}) stratifiées sont adhérées et intégrées les unes aux autres au moins dans la région de la portion d'extrémité frontale (14) et d'une portion de base (12).

6. Borne engagée à la presse (10)
selon l'une quelconque des revendications 1 à 5,
dans laquelle les unités à borne engagées à la presse (10_{L}) stratifiées sont séparées les unes des autres au moins dans la région de la portion de contact à la presse (15).

7. Borne engagée à la presse (210)
selon l'une quelconque des revendications 1 à 6,
dans laquelle la pluralité d'unités à borne engagées à la presse (210_{L}) sont formées avec des matériaux en plaque respectivement différents.

8. Borne engagée à la presse (310) selon la revendication 7,
dans laquelle les unités à borne engagées à la presse (310_{LE}), parmi la pluralité d'unités à borne engagées à la presse (310_{L}), qui sont situées à des positions écartées du centre dans la direction de stratification d'une même distance, sont réalisées d'un même matériau en plaque.

9. Borne engagée à la presse (410)
selon l'une quelconque des revendications 1 à 8,
dans laquelle la pluralité d'unités à borne engagées à la presse (410_{L}) sont formées de matériaux en plaque respectifs ayant des épaisseurs différentes.

10. Borne engagée à la presse (410) selon la revendication 9,
dans laquelle les unités à borne engagées à la presse (410_{LE}), parmi la pluralité d'unités à borne engagées à la presse (410_{L}), qui sont situées à des positions écartées du centre dans la direction de stratification d'une même distance, sont réalisées avec des matériaux en plaque respectifs ayant la même épaisseur.

11. Borne engagée à la presse (510)
selon l'une quelconque des revendications 1 à 10,
dans laquelle la pluralité d'unités à borne engagées à la presse (510_{L}) sont différentes les unes des autres dans la largeur (Wo) de la portion de contact à la presse (515).

12. Borne engagée à la presse (510) selon la revendication 11,
dans laquelle la largeur (Wo) de la portion de contact à la presse (515) de l'unité à borne engagée à la presse (510_{L}) devient d'autant plus étroite que la position de ladite unité à borne engagée à la presse (510) s'éloigne du centre dans la direction de stratification.

13. Borne engagée à la presse (610) selon la revendication 11,
dans laquelle, en supposant que la forme de section transversale de la paroi intérieure (31W) du trou traversant est un arc, la largeur (W_{OE}) de la portion de contact à la presse (615) de l'unité à borne engagée à la presse (610_{LE}), parmi les unités à borne engagées à la presse (610_{L}), qui est la couche la plus extérieure dans la direction de stratification, est plus large que la longueur (LC_{E}) de la corde de l'arc, qui est espacée du centre du cercle à raison de la moitié de l'épaisseur de ladite borne engagée à la presse (610), et la largeur (W_{OM}) de la portion de contact à la presse (615) de l'unité à borne engagée à la presse (610_{LM}) qui est adjacente au côté intérieur de l'unité à borne engagée à la presse (610_{L}) de la couche la plus extérieure est plus étroite que la longueur (LC_{E}) de la corde.

14. Borne engagée à la presse (10_{V1} - 10_{V4}) selon l'une quelconque des revendications 1 à 13,
dans laquelle, sur les faces latérales respectives de la paire de portions (15a) ramifiées depuis la portion d'extrémité frontale (14), sont formées des portions en projection (15p_{V1} - 15p_{V4}) qui se projettent en direction des faces latérales respectives opposées.

15. Borne engagée à la presse (10_{V1}, 10v₃) selon la revendication 14, dans laquelle les portions en projection (15p_{V1}, 15p_{V3}) sont formées d'une manière telle que les portions de racines respectives (15p_{B}) de celles-ci s'étendant depuis les faces latérales ont la forme d'une pièce effilée.

16. Module semi-conducteur (100) comprenant :
- un dispositif semi-conducteur (23) monté sur un conducteur en ruban (22) d'un circuit formé sur une carte à circuits (21) ; et
- la borne engagée à la presse (710) selon l'une quelconque des revendications 1 à 15,
l'autre portion d'extrémité (711) de celle-ci, à l'opposé de la portion d'extrémité frontale, est électriquement connectée à l'électrode du dispositif semi-conducteur (23).

17. Module semi-conducteur (100) selon la revendication 16,
dans lequel le dispositif semi-conducteur (23) est formé d'un matériau semi-conducteur à large saut de bande.

18. Module semi-conducteur (100) selon la revendication 17,
dans lequel le matériau semi-conducteur à large saut de bande est un matériau quelconque parmi carbure de silicium, nitrure de gallium, et diamant.
